# EUROPÄISCHE PATENTSCHRIFT

(11) **EP 1 145 331 B1**
(45) Veröffentlichungstag und Bekanntmachung des Hinweises auf die Patenterteilung: **17.07.2013**
(21) Anmeldenummer: 00987172.4
(22) Anmeldetag: 20.11.2000
(51) Int. Cl.: H01L 33/06, H01L 33/32, H01S 5/343

(54) **STRAHLUNGSEMITTIERENDE HALBLEITERVORRICHTUNG MIT MEHRFACH-QUANTENTOPF-STRUKTUR**
LIGHT EMITTING SEMICONDUCTOR DEVICE COMPRISING A MULTIPLE QUANTUM WELL STRUCTURE
DISPOSITIF A SEMICONDUCTEUR ÉLECTROLUMINESCENT DOTE D'UNE STRUCTURE DE PUITS QUANTIQUE MULTICOUCHE

(30) Priorität: 19.11.1999 DE 19955747
(43) Veröffentlichungstag der Anmeldung: 17.10.2001
(73) Patentinhaber: OSRAM Opto Semiconductors GmbH, 93055 Regensburg (DE)
(72) Erfinder: HÄRLE, Volker, 93164 Laaber (DE); HAHN, Berthold, 93155 Hemau (DE); LUGAUER, Hans-Jürgen, 93161 Sinzing (DE); BOLAY, Helmut, 93178 Beratzhausen (DE); BADER, Stefan, 93080 Pentling - Matting (DE); WEIMAR, Andreas, 93055 Regenburg (DE); EISERT, Dominik, 93049 Regensburg (DE); STRAUSS, Uwe, 93077 Bad Abbach (DE); VÖLKL, Johannes, 91056 Erlangen (DE); ZEHNDER, Ulrich, 93191 Rettenbach (DE); LELL, Alfred, 93142 Maxhütte-Haidhof (DE)
(74) Vertreter: Epping - Hermann - Fischer
(86) Internationale Anmeldenummer: PCT/DE2000/004089
(87) Internationale Veröffentlichungsnummer: WO 2001/039282

(56) Entgegenhaltungen:
- EP-A- 0 731 510
- EP-A- 0 833 395
- EP-A- 0 908 988
- WO-A-98/31055
- US-A- 5 684 309
- US-A- 5 831 277
- PATENT ABSTRACTS OF JAPAN vol. 1998, no. 14, 31. Dezember 1998 (1998-12-31) -& JP 10 242512 A (TOSHIBA CORP), 11. September 1998 (1998-09-11)

## Beschreibung

Die Erfindung betrifft eine strahlungsemittierende Halbleitervorrichtung mit Mehrfach-Quantentopf-Struktur, in der Topfschichten und Barriereschichten aus verschiedenen Arten von Halbleiterschichten abwechselnd geschichtet sind.

Eine derartige Vorrichtung ist beispielsweise aus der EP 0 666 624 B1 oder aus Journal of Crystal Growth 189/190 (1998) p. 786-789 bekannt.

Der hohe Quantenwirkungsgrad von Indium-Gallium-Nitrid-(InGaN-)-basierten LEDs und Laserdioden wird durch das selbstorganisierte Wachstum indiumreicher Inseln im aktiven Quantentrog oder Quantentopf verursacht. Dadurch werden die injizierten Ladungsträger räumlich an diesen Inseln lokalisiert und von nichtstrahlender Rekombination an Gitterdefekten abgehalten.

Die Nukleation dieser Quantenpunkte muß durch geeignete Pufferschichten eingeleitet werden. Insbesondere eignen sich indiumhaltige Strukturen vor der eigentlichen aktiven Zone als Pufferschicht. Indiumhaltige nitridische Halbleiter (GaₓAl_{y}In_{1-(x+y)}N-Halbleiter) neigen zur Entmischung und Bildung von indiumhaltigen Phasen. Dies führt an der Wachstumsoberfläche zu variierenden Verspannungsfeldern, die die Bildung indiumreicher Inseln im aktiven Quantentrog begünstigt. Ca. 100 nm dicke GaInN-Schichten können vor der aktiven Zone abgeschieden werden, um die GaInN-Quantenpunkt-Nukleation zu verbessern.

Bisher kann ein optimaler Wirkungsgrad mit z. B. 2- bis 10-fach-Quantentopf-Strukturen erreicht werden. Wie experimentell gezeigt werden kann, werden die emittierten Photonen ausschließlich in den beiden obersten (d.h. der p-Seite nächsten) Quantentrögen erzeugt. Bei geeigneter Wahl der Wachstumsparameter wird erreicht, daß die Emission ausschließlich im obersten der Quantentöpfe erfolgt. Die unteren Quantentöpfe dienen zur Verbesserung der Nukleation der GaInN-Inseln im obersten Quantentopf. Wird auf sie verzichtet, so sinkt die optische Ausgangsleistung um über 50 % ab. Allerdings führen diese Quantentöpfe zu einer erheblichen Erhöhung der Flußspannung. Die Flußspannung kann durch Verringern der Topfanzahl auf Kosten der Quanteneffizienz verbessert werden. Die Piezofelder, die zur beobachteten Erhöhung der Flußspannung führen, können durch hohe Dotierniveaus im Quantentopfbereich kompensiert werden. Dadurch wird allerdings die Kristallqualität der aktiven Schicht gestört bzw. das Injektionsverhalten verschlechtert und so die interne Quanteneffizienz verringert.

In der Druckschrift JP 10-242512 A ist ein strahlungsemittierendes Nitrid-Halbleiterbauteil angegeben.

Die Druckschrift EP 1 017 113 A1 betrifft ein weiteres strahlungsemittierendes Nitrid-Halbleiterbauteil.

Der Erfindung liegt die Aufgabe zugrunde, eine strahlungsemittierende Halbleitervorrichtung der eingangs genannten Art demgegenüber zu verbessern.

Diese Aufgabe löst die Erfindung mit den Merkmalen des Patentanspruchs 1.

Erfindungsgemäß ist eine Mehrfach-Quantentopf-Struktur mit Quantentopfschichten und Barriereschichten aus verschiedenen Arten von Halbleiterschichten, die abwechselnd aufeinander geschichtet sind, vorgesehen, in der die Quantentopfschichten dünne Schichten einer ersten Zusammensetzung auf der Basis eines Nitrid-Halbleitermaterials mit einer ersten Elektronenenergie und die Barriereschichten demgegenüber dickere Schichten einer zweiten Zusammensetzung eines Nitrid-Halbleitermaterials mit gegenüber der ersten Elektronenenergie höheren Elektronenenergie sind. Als strahlender Quantentopf wirkt, in Aufwachsrichtung gesehen, erst eine der letzten Quantentopfschichten oder die letzte Quantentopfschicht. Für diese bilden die vorgeordneten Quantentopfschichten, die im Wesentlichen nicht strahlen, und die Barriereschichten ein Übergitter aus.

Bei einer besonders bevorzugten Weiterbildung sind im Übergitter die Quantentopfschichten dünne Aluminium-Gallium-Indium-Nitrid-Schichten und die Barriereschichten demgegenüber dickere Gallium-Nitrid-Schichten und weist der aktive Quantentopf Indium-Gallium-Nitrid auf.

Innerhalb mindestens einer Quantentopfschicht des Übergitters nimmt der In-Gehalt in Aufwachsrichtung, d. h. in Richtung zur strahlenden Quantentopfschicht hin, zu. Vorzugsweise liegt hierbei der Indium-Gehalt entfernt von der strahlenden Quantentopfschicht unterhalb 5%.

Mindestens eine der Quantentopfschichten des Übergitters weist mindestens ein Einzelschichtenpaar auf, von dem die in Aufwachsrichtung erste Einzelschicht einen geringeren Indium-Gehalt aufweist als die in Aufwachsrichtung zweite Einzelschicht. Vorzugsweise weiset diese Quantentopfschicht eine Mehrzahl von Einzelschichten auf, deren Indium-Gehalt ausgehend von der am weitesten entfernt von der strahlenden Quantentopfschicht liegenden Einzelschicht zur zu der strahlenden Quantentopfschicht nächstliegenden Einzelschicht hin stufenweise zunimmt. Die Stufen der Zunahme des Indium-Gehalts sind besonders bevorzugt kleiner 5%. Weiterhin besonders bevorzugt ist der Indium-Gehalt der am weitesten entfernt von der strahlendenQuantentopfschicht liegenden Einzelschicht kleiner als 5%. Vorteilhafterweise liegt die Dicke der Einzelschichten im Bereich weniger Monolagen besonders bevorzugt etwa eine Monolage.

Der besondere Vorteil der stufenweisen Zunahme des In-Gehalts besteht darin, dass ein Potentialverlauf entsteht, der einem Dreieckspotential ähnlich ist, insbesondere für den Fall, dass die Dicke der Einzelschichten die einer Monolage nicht wesentlich übersteigt. Folglich ist der Unterschied des Energieniveaus in den Barriereschichten und dem sich für ein Elektron ergebenden Energieniveau in der Quantentopfschicht nicht größer als bei einer rechteckigen Quantentopfschicht mit wesentlich geringerem Indium-Gehalt als die oberste Einzelschicht der gestuften Quantentopfschicht. Dadurch wird erreicht, dass die Vorteile eines reduzierten Gesamt-Indium-Gehalts beibehalten werden, aber gleichzeitig durch den hohen Indium-Gehalt der letzten Einzelschicht die Verspannung so beeinflusst wird, dass die Nukleation von InGaN-reichen Phasen verbessert und somit die Quanteneffizienz gesteigert wird.

Ein weiterer Vorteil ergibt sich aus folgendem: Das epitaktische Wachstum von Indium-haltigen III-V-Halbleitern (z. B. InGaAs, InGaN) wird durch den relativ großen Atomradius des Indiums erschwert. Bei konstanten Flüssen der Gruppe III-Komponenten baut sich Indium daher verzögert ein. Die Indium-Konzentration steigt während des Wachstums an und nähert sich exponentiell einem Gleichgewichtswert an. Während der Anreicherungsphase bildet sich auf der Wachstumsoberfläche eine bestimmte Indium-Bedeckung. Erst wenn diese Bedeckung erreicht ist, wird gleichbleibend viel Indium in den Kristall eingebaut. Wird allerdings zu viel Indium angeboten, formt das auf der Oberfläche vorhandene Indium metallische Tröpfchen, die die Qualität der abgeschiedenen Schichten vermindern. Vor allem aber erzeugen solche Indium-Tröpfchen am p-n-Übergang Nebenschlüsse, die neben der Quanteneffizienz auch die Stabilität gegenüber elektrostatischer Entladung (ESD) vermindern. Diese Effekte werden dadurch vermindert, daß zunächst Indiumhaltige Schichten mit geringem Indium-Gehalt, bevorzugt weniger als 5%, abgeschieden werden, um dann bei darauffolgenden Schichten den Indiumgehalt zu steigern. Bei der aktiven Schicht selbst ist der Unterbau durch die Quantentopfschichten dann schon derart vorbereitet, dass InGaN-Zusammensetzungen mit höherem Indium-Gehalt abgeschieden werden können.

Die Nukleation von Indium-reichen Phasen wird durch den sich erhöhenden Indium-Gehalt in der oder den Quantentopfschichten vorteilhafterweise verbessert. Die schädliche Ausbildung von Indium-Tröpfchen wird zumindest erheblich vermindert.

Weitere vorteilhafte Weiterbildungen und Ausgestaltungen der Erfindung sind Gegenstand von Unteransprüchen.

Die Erfindung wird nachfolgend anhand eines Ausführungsbeispiels mit Hilfe der Figuren der Zeichnung näher erläutert.

Es zeigen:
- Figur 1a,b: eine schematische Darstellung des Schichtaufbaus einer Vorrichtung gemäß der Erfindung,
- Figur 2: eine schematische Darstellung der Quantentopf-Struktur der Vorrichtung gemäß Figur 1,
- Figur 3: eine schematische Darstellung der Quantentopf-Struktur üblicher Art, und
- Figur 4: eine schematische Darstellung des Verlaufs des Leitungsbandes gemäß einer besonders bevorzugten Ausführungsform der Erfindung.

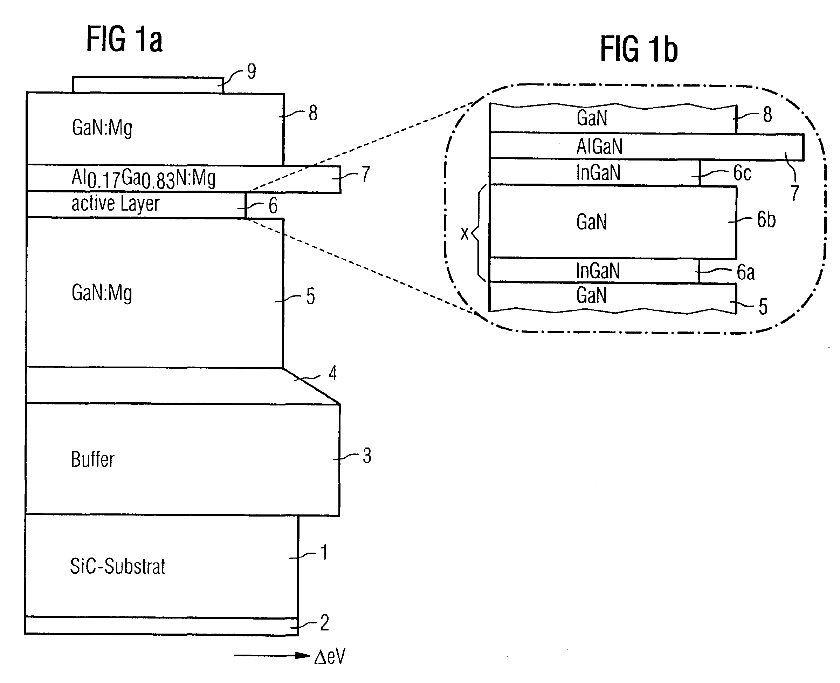

Gemäß Figur 1a ist auf einem Substrat 1 aus Siliziumcarbid (SiC), an dem eine erste Kontakt-Elektrode 2 angeschlossen ist, zunächst eine Pufferschicht 3 aus Aluminium-Gallium-Nitrid (AlGaN) gebildet. Darüber schließt sich eine weitere Schicht 4 aus Aluminium-Gallium-Nitrid an. Über der Schicht 4 sind eine weitere Pufferschicht 5 aus Silizium-dotiertem Galliumnitrid und darüber ist die noch näher zu erläuternde Quantentopf-Struktur 6a,b angeordnet, an die die eigentliche aktive Schicht 6c anschließt. Über der aktiven Schicht 6 ist eine weitere Schicht 7 aus Aluminium-Gallium-Nitrid angeordnet, die als Elektronenbarriere dient. Vorzugsweise ist diese Schicht 7 mit Magnesium dotiert. Zwischen den Schichten 6 und 7 kann eine weitere nicht gezeichnete GaN-Schicht angeordnet sein. Über der Schicht 7 ist eine Galliumnitrid-Schicht 8 angeordnet, auf der eine zweite Kontakt-Elektrode 9 der Vorrichtung vorgesehen ist.

Die rechte Seite des Schichtaufbaus zeigt schematisch angedeutet die Bandlücke der einzelnen Schichten zwischen dem Valenz- und dem Leitungsband.

Funktionell dient die Pufferschicht 3 als Wachstumsschicht, die erforderlich ist, um auf dem Siliziumcarbid-Substrat 1 die LED-Struktur aufwachsen zu können. Die weitere Aluminium-Gallium-Nitrid-Schicht 4 zwischen den Schichten 3 und 5 hat einen sich in Richtung der Gallium-Nitrid-Schicht 5 hin ändernden Aluminiumgehalt. Die Gallium-Nitrid-Schicht 5 ist vorzugsweise siliziumdotiert. Die über der aktiven Schicht 6 angeordnete Schicht 7 aus magnesisumdotiertem Aluminium-Gallium-Nitrid dient als Elektronenbarriere.

Dieser grundsätzlicher Aufbau der Figur 1a kann standardmäßig für Gallium-Aluminium-Indium-Nitrid (LEDs) verwendet werden.

Figur 1b ist eine vergrößerte Darstellung der aktiven Schicht 6 gemäß der Erfindung. Die Schicht mit der Quantentopf-Struktur 6 ist aufgebaut, indem zwischen einzelnen Gallium-Nitrid-(GaN-)Schichten 6b Schichten 6a aus Gallium-Indium-Nitrid (GaInN) angeordnet sind. Die eigentlich aktive, d.h. lichtabstrahlende Schicht 6c aus Gallium-Indium-Nitrid (GalnN) schließt sich an die oberste Gallium-Nitrid-Schicht 6b an.

Wie ersichtlich, wechseln sich unterschiedlich dicke Schichten 6a und 6b ab. Die dünneren Schichten 6a aus Indium-Gallium-Nitrid und die dickeren Schichten 6b aus Gallium-Nitrid bilden dabei Übergitter, bei denen die Quantentöpfe 6a dünn sind, d. h. dünner als 3 nm und die Schichten 6b 3nm und darüber. Die Herstellung der Schichten erfolgt durch Gasphasen- oder Molekularstrahlepitxie. Dabei ist ein langsames Wachstum von 1-10 nm/min, bevorzugt 1-2nm/min, bei niedrigen Temperaturen um 700 C° vorgesehen.

Der Indiumgehalt liegt unter 24%, vorzugsweise jedoch unter 20 % und ist deshalb vorzugsweise gegenüber üblichen Indiumgehalten reduziert. Die in der Figur nur einmal gezeichneten Schichten 6a und 6b können mehrmals übereinander angeordnet sein, vorzugsweise wiederholt sich die Struktur x=3mal. An die oberste Gallium-Nitrid-Schicht 6b schließt sich die eigentlich aktive, d. h. leuchtende Schicht 6c aus Indium-Gallium-Nitrid an.

Vorzugsweise kann vorgesehen sein, die Quantentopfstruktur 6a, 6b mit Silizium in der Konzentration 10¹⁷ bis 10¹⁸cm⁻³ zu dotieren. Damit ergibt sich noch einmal eine deutliche Verbesserung im Vergleich zu einer undotierten Struktur.

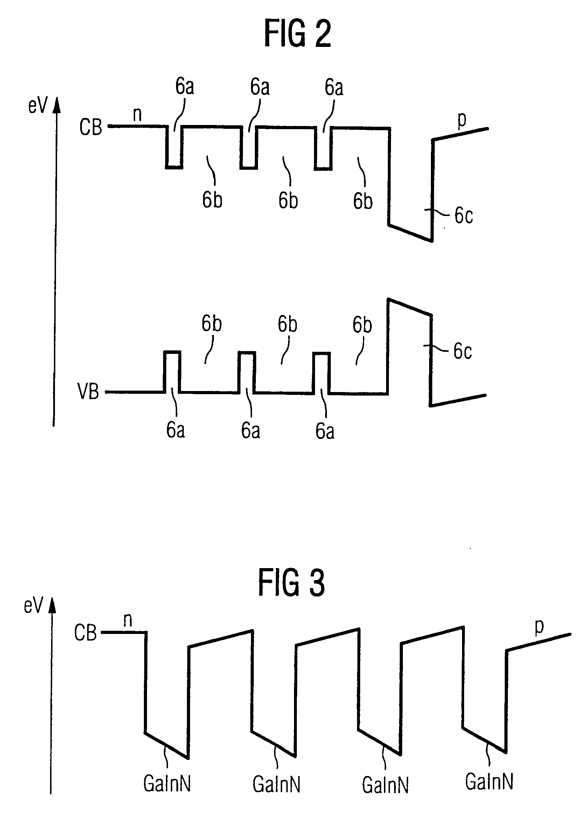

Figur 2 zeigt die Energieverhältnisse für das Valenzband VB und das Leitungsband CB. In Ordinatenrichtung ist die Elektronenenergie aufgetragen, in Abszissenrichtung sind die Quantentöpfe mit einer Breite, die der Schichtdicke entsprechen, aufgetragen. An die oberste Gallium-Nitrid-Schicht 6b schließt sich die tatsächlich aktive Schicht 6c an.

Figur 3 zeigt demgegenüber das Valenzband mit dickeren Quantentöpfen aus Gallium-Indium-Nitrid als bei der Erfindung. Durch die Schrägen angedeutet, ist der Effekt der piezoelektrischen Felder, die sich durch die Verspannungen ergeben.

Durch die erfindungsgemäße Verwendung von GaInN/GaN-Übergittern mit dünnen Quantentöpfen (bis ca. 2 nm Quantentopfbreite) bei einem Schichtaufbau gemäß Figur 1 und Quantentopf-Verhältnissen gemäß Figur 2 kann die Flußspannung deutlich gesenkt werden und dabei die hohe interne Quanteneffizienz der Indium-Gallium-Nitrid-basierten optischen Halbleitervorrichtung erhalten werden. Die sich sonst ausbildenden Piezofelder werden ganz vermieden oder wirken sich praktisch nicht mehr aus. Im Vergleich zu herkömmlichen Einfach-Quantentopf-Strukturen, bei denen vor dem aktiven Topf kein Gallium-Indium-Nitrid-Übergitter abgeschieden wird, zeigt der erfindungsgemäße Vorrichtungsaufbau einen verdoppelten Konversionswirkungsgrad.

Unter Übergitter versteht man allgemein eine insbesondere periodische Aufeinanderfolge von nur wenigen Atomlagen dicken Schichten. Das Übergitter wird vom aktiven Trog durch eine GaN- oder AlGaN-Barriere getrennt (>3nm). Die Silizium-Dotierung der Quantentopfstruktur ist deutlich verbessert im Vergleich zur undotierten Struktur.

Im Vergleich mit bekannten Übergitterstrukturen hat der erfindungsgemäße Vorrichtungsaufbau eine um >0,5V gesenkte Flußspannung.

Im Vergleich zu SQW(Single Quantum Well)-Strukturen, vor deren aktivem Quantentopf kein GaInN Übergitter abgeschieden wurden, konnte der Konversionswirkungsgrad verdoppelt werden.

Durch die Kombination von dünnen, auch indiumarmen, optisch inaktiven Quantentrögen ("Pre-Wells") mit einem aktiven Quantentopf 6c kann das Emissionsverhalten der bisher bekannten Mehrfach-Quantentopf-Strukturen erhalten und die Flußspannung gesenkt werden. Die dünnen GaInN-Quantentöpfe verbessern die Qualität des aktiven Quantentopfs, während durch die geringe Schichtdicke der "Pre-Wells" und ihrem niedrigen Indiumgehalt die Ausbildung von störenden Piezofeldern verringert wird. Die Flußspannung wird daher durch diese Nukleationsschicht gegenüber einer SQW-Struktur nicht erhöht.

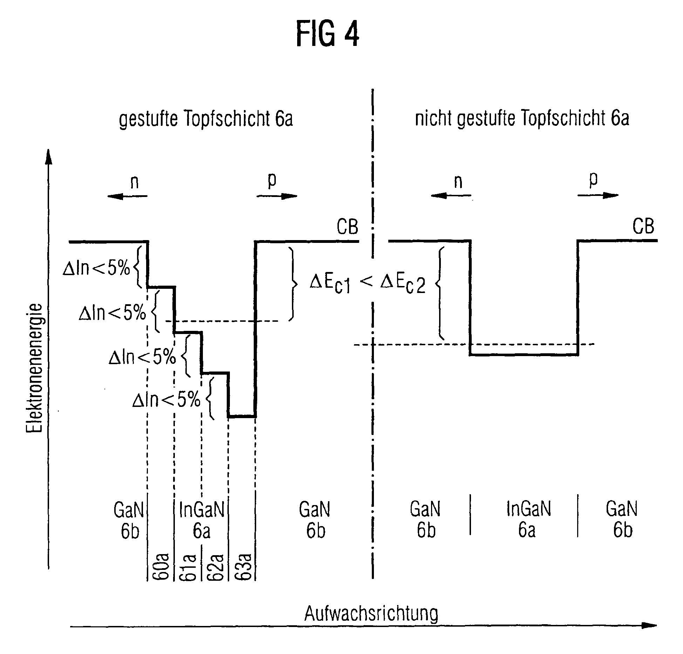

Die Figur 4 zeigt den Verlauf des Leitungsbandes in einer InGaN-Quantentopfschicht 6a zwischen zwei GaN-Barriereschichten, wobei die GaN-Quantentopfschicht 6a aus insgesamt 4 Einzelschichten 60a bis 63a besteht. Der Indium-Gehalt nimmt ausgehend von der am weitesten entfernt von einer strahlenden Quantentopfschicht 6c liegenden Einzelschicht 60a zur zu der strahlungsaktiven Quantentopfschicht 6c nächstliegenden Einzelschicht 63a hin stufenweise zu. Die Stufen der Zunahme des Indium-Gehalts sind kleiner 5% und der Indium-Gehalt der am weitesten entfernt von der strahlenden Quantentopfschicht 6c liegenden Einzelschicht 60a ist kleiner als 5%. Die Schichtdicke jeder der Einzelschichten 60a bis 63a liegt im Bereich weniger Monolagen oder entspricht etwa einer Monolage der Zusammensetzung.

Dadurch entsteht ein Potentialverlauf, der einem Dreieckspotential ähnlich ist. Folglich ist der Unterschied des Energieniveaus in den Barriereschichten und dem sich für in Elektron ergebenden Energieniveau in der gestuften Quantentopfschicht nicht größer als bei einer rechteckigen Quantentopfschicht (in der Figur auf der rechten Seite dargestellt) mit wesentlich geringerem Indium-Gehalt als die oberste Einzelschicht der gestuften Quantentopfschicht. Dadurch wird erreicht, dass die Vorteile eines reduzierten Gesamt-Indium-Gehalts beibehalten werden, aber gleichzeitig durch den hohen Indium-Gehalt der letzten Einzelschicht die Verspannung so beeinflußt wird, dass die Nukleation von InGaN-reichen Phasen verbessert und somit die Quanteneffizienz gesteigert wird.

Die Beschreibung der Erfindung anhand des obigen Ausführungsbeispiels ist nicht als Beschränkung der Erfindung hierauf zu verstehen.

## Patentansprüche

1. Strahlungsemittierende Halbleitervorrichtung mit einer Mehrfach-Quantentopf-Struktur, in der Quantentopfschichten und Barriereschichten aus verschiedenen Arten von Halbleiterschichten abwechselnd aufeinander geschichtet sind, wobei
Quantentopfschichten (6a) einer ersten Zusammensetzung auf der Basis eines Nitrid-Halbleitermaterials mit einer ersten Elektronenenergie und Barriereschichten (6b) einer zweiten Zusammensetzung eines Nitrid-Halbleitermaterials mit gegenüber der ersten Elektronenenergie höheren Elektronenenergie vorgesehen sind, denen in Aufwachsrichtung gesehen eine strahlende Quantentopfschicht (6c) einer dritten Zusammansetzung auf der Basis eines Gallium-Indium-Nitrid-Halbleiternmaterials mit gegenüber der ersten Elektronenenergie geringeren Elektronenenergie nachgeordnet ist, für den die vorgeordneten im Wesentlichen nicht strahlenden Quantentopfschichten (6a) und die Barriereschichten (6b) ein Übergitter bilden, **dadurch gekennzeichnet, dass** mindestens eine der Quantentopfschichten (6a) des Übergitters mindestens ein Einzelschichtenpaar (60a, 61a) aufweist, von dem die in Aufwachsrichtung erste Einzelschicht (60a) einen geringeren Indium-Gehalt aufweist als die in Aufwachsrichtung zweite Einzelschicht (61a).

2. Strahlungsemittierende Halbleitervorrichtung nach Patentanspruch 1, bei der die Topfschichten (6a) dünnere Aluminium-Indium-Gallium-Nitrid-Schichten und die Barriereschichten (6b) demgegenüber dickere Gallium-Nitrid- oder Aluminium-Gallium-Nitrid-Schichten sind.

3. Strahlungsemittierende Halbleitervorrichtung nach Patentanspruch 1 oder 2, bei der sich der strahlende Quantentopf (6c) an die oberste Barriereschicht (6b) anschließt.

4. Strahlungsemittierendes Halbleitervorrichtung nach einem der Patentansprüche 1 bis 3, bei der die Schichtdicke des strahlendenQuantentopfs (6c) größer ist als die Schichtdicke der Quantentopfschichten (6a) des Übergitters.

5. Strahlungsemittierende Halbleitervorrichtung nach einem der Patentansprüche 1 bis 4, bei der die Quantentopfschichten (6a) dünner als 2nm sind und die Barriereschichten (6b) 3nm dick oder dicker sind.

6. Strahlungsemittierende Halbleitervorrichtung nach einem der Patentansprüche 2 bis 5, bei der die Quantentopf- und Barriereschichten (6a, 6b) mit Silizium dotiert sind.

7. Strahlungsemittierende Halbleitervorrichtung nach Patentanspruch 6, bei der die Dotierstoffkonzentration von 10¹⁷ bis 10¹⁸cm⁻³ ist.

8. Strahlungsemittierende Halbleitervorrichtung nach einem der vorhergehenden Patentansprüche, bei der die zweite Einzelschicht (61a) einen um weniger als 5% höheren Indium-Gehalt aufweist als die erste Einzelschicht (60a).

9. Strahlungsemittierende Halbleitervorrichtung nach einem der vorhergehenden Patentansprüche, bei der die mindestens eine der Quantentopfschichten (6a) des Übergitters eine Mehrzahl von Einzelschichten (60a,61a,62a,63a) aufweist, deren Indium-Gehalt ausgehend von der am weitesten entfernt von der strahlenden Quantentopfschicht (6c) liegenden Einzelschicht (60a) zur zu der strahlenden Quantentopfschicht (6c) nächstliegenden Einzelschicht (63a) hin stufenweise zunimmt.

10. Strahlungsemittierende Halbleitervorrichtung nach einem der vorhergehenden Patentansprüche, bei der die Stufen der Zunahme des Indiumgehalts kleiner 5% sind.

11. Strahlungsemittierende Halbleitervorrichtung nach einem der vorhergehenden Patentansprüche, bei der der Indium-Gehalt der am weitesten entfernt von der strahlenden Quantentopfschicht (6c) liegenden Einzelschicht (60a) kleiner als 5% ist.

## Claims

1. Radiation-emitting semiconductor device with a multiple quantum well structure, in which quantum well layers and barrier layers comprising various types of semiconductor layers are alternately layered, in which device quantum well layers (6a) of a first composition based on a nitride semiconductor material with a first electron energy and barrier layers (6b) of a second composition of a nitride semiconductor material with electron energy which is higher in comparison with the first electron energy are provided, followed, seen in the direction of growth, by a radiating quantum well layer (6c) of a third composition based on a gallium-indium-nitride semiconductor material with electron energy which is lower in comparison with the first electron energy, for which the essentially non-radiating quantum well layers (6a) arranged in front and the barrier layers (6b) form a superlattice, **characterized in that** at least one of the quantum well layers (6a) of the superlattice has at least one pair of single layers (60a, 61a), of which the first single layer (60a) in the direction of growth has a lower indium content than the second single layer (61a) in the direction of growth.

2. Radiation-emitting semiconductor device according to Patent Claim 1, in which the well layers (6a) are thinner aluminum-indium-gallium-nitride layers and the barrier layers (6b) are gallium-nitride or aluminum-gallium-nitride layers which are thicker in comparison.

3. Radiation-emitting semiconductor device according to Patent Claim 1 or 2, in which the radiating quantum well (6c) follows the uppermost barrier layer (6b).

4. Radiation-emitting semiconductor device according to one of Patent Claims 1 to 3, in which the layer thickness of the radiating quantum well (6c) is greater than the layer thickness of the quantum well layers (6a) of the superlattice.

5. Radiation-emitting semiconductor device according to one of Patent Claims 1 to 4, in which the quantum well layers (6a) are thinner than 2 nm and the barrier layers (6b) are 3 nm thick or thicker.

6. Radiation-emitting semiconductor device according to one of Patent Claims 2 to 5, in which the quantum well and barrier layers (6a, 6b) are doped with silicon.

7. Radiation-emitting semiconductor device according to Patent Claim 6, in which the dopant concentration is from 10¹⁷ to ₁₀¹⁸ cm⁻³.

8. Radiation-emitting semiconductor device according to one of the preceding patent claims, in which the second single layer (61a) has an indium content higher by less than 5% than the first single layer (60a).

9. Radiation-emitting semiconductor device according to one of the preceding patent claims, in which the at least one of the quantum well layers (6a) of the superlattice has a plurality of single layers (60a, 61a, 62a, 63a) whose indium content increases step by step from the single layer (60a) lying furthest away from the radiating quantum well layer (6c) to the single layer (63a) lying closest to the radiating quantum well layer (6c).

10. Radiation-emitting semiconductor device according to one of the preceding patent claims, in which the steps of the increase in the indium content are smaller than 5%.

11. Radiation-emitting semiconductor device according to one of the preceding patent claims, in which the indium content of the single layer (60a) lying furthest away from the radiating quantum well layer (6c) is less than 5%.

## Revendications

1. Ensemble semi-conducteur émettant un rayonnement et doté d'une structure à cuvettes quantiques dans laquelle des couches à cuvettes quantiques et des couches de barrière constituées de différents types de couches semiconductrices sont superposées en alternance,
les couches (6a) à cuvettes quantiques d'une première composition à base d'un matériau semi-conducteur au nitrure présentant une première énergie d'électrons et des couches de barrière (6b) d'une deuxième composition d'un matériau semi-conducteur au nitrure dont l'énergie des électrons est plus élevée que la première énergie des électrons étant prévues, avec ensuite dans la direction de croissance une couche (6c) à cuvettes quantiques émettant un rayonnement, d'une troisième composition à base d'un matériau semi-conducteur au nitrure de gallium et d'indium et dont l'énergie des électrons est plus basse que la première énergie des électrons, les couches (6a) à puits quantiques précédentes, qui n'émettent essentiellement pas de rayonnement formant avec les couches de barrière (6b) une superstructure en réseau pour cette couche,
**caractérisé en ce que**
au moins l'une des couches (6a) à cuvettes quantiques de la superstructure en réseau présente au moins une paire de couches distinctes (60a, 61a) parmi lesquelles la couche distincte (60a) située en premier dans la direction de croissance présente une plus basse teneur en indium que la couche distincte (61a) située en deuxième position dans la direction de croissance.

2. Ensemble semi-conducteur émettant un rayonnement selon la revendication 1, dans lequel les couches (6a) à cuvettes sont de minces couches de nitrure d'aluminium, d'indium et de gallium et les couches de barrière (6b) sont des couches plus épaisses de nitrure de gallium ou de nitrure de gallium et d'aluminium.

3. Ensemble semi-conducteur émettant un rayonnement selon les revendications 1 ou 2, dans lequel la cuvette quantique (6c) émettant un rayonnement est la couche supérieure de barrière (6b).

4. Ensemble semi-conducteur émettant un rayonnement selon l'une des revendications 1 à 3, dans lequel l'épaisseur de la couche à cuvettes quantiques (6c) émettant un rayonnement est plus grande que l'épaisseur des couches (6a) à cuvettes quantiques de la superstructure en réseau.

5. Ensemble semi-conducteur émettant un rayonnement selon l'une des revendications 1 à 4, dans lequel les couches (6a) à cuvettes quantiques ont une épaisseur inférieure à 2 nm et les couches de barrière (6b) ont une épaisseur de 3 nm ou plus.

6. Ensemble semi-conducteur émettant un rayonnement selon l'une des revendications 2 à 5, dans lequel les couches à cuvettes quantiques et les couches de barrière (6a, 6b) sont dopées au silicium.

7. Ensemble semi-conducteur émettant un rayonnement selon la revendication 6, dans lequel la concentration en substance dopante est comprise entre 10¹⁷ et 10¹⁸ cm⁻³.

8. Ensemble semi-conducteur émettant un rayonnement selon l'une des revendications précédentes, dans lequel la deuxième couche distincte (61a) présente une teneur en indium d'au moins 5 % supérieure à celle de la première couche distincte (60a).

9. Ensemble semi-conducteur émettant un rayonnement selon l'une des revendications précédentes, dans lequel la ou au moins une de les couches (6a) à cuvettes quantiques de la superstructure en réseau présentent plusieurs couches distinctes (60a, 61a, 62a, 63a) dont la teneur en indium augmente par gradins entre la couche distincte (60a) située le plus loin de la couche (6c) à cuvettes quantiques émettant un rayonnement et la couche distincte (63a) située le plus près de la couche (6c) à cuvettes quantiques émettant un rayonnement.

10. Ensemble semi-conducteur émettant un rayonnement selon l'une des revendications précédentes, dans lequel les gradins d'augmentation de la teneur en indium sont inférieurs à 5 %.

11. Ensemble semi-conducteur émettant un rayonnement selon l'une des revendications précédentes, dans lequel la teneur en indium de la couche distincte (60a) située le plus loin de la couche (6c) à cuvettes quantiques émettant un rayonnement est inférieure à 5 %.
